# EUROPEAN PATENT APPLICATION

(11) **EP 4 653 832 A1**
(43) Date of publication of application: **26.11.2025**
(21) Application number: 23916963.4
(22) Date of filing: 24.05.2023
(51) Int. Cl.: G01K 7/22

(54) **TEMPERATURE MEASUREMENT SYSTEM AND METHOD FOR TEMPERATURE CONTROL OF HOT SURFACE IGNITER**

(30) Priority: 17.01.2023 CN 202310062859
(71) Applicant: CHONGQING LE-MARK TECHNOLOGY CO., LTD., Jiulongpo District Chongqing 401329 (CN)
(72) Inventor: LEIGH, Peter, Chongqing 401329 (CN)
(74) Representative: Pons IP
(86) International application number: PCT/CN2023/096024
(87) International publication number: WO 2024/152490

(57) **Abstract**

A temperature measurement system for temperature control of a hot surface igniter, comprising a power supply module, configured for supplying power to the hot surface igniter; and further comprising an acquisition module, configured for acquiring a resistance value of the hot surface igniter; and a processing module, preset with a resistance-temperature meter and configured for acquiring a temperature value corresponding to a current resistance value from the preset resistance-temperature meter according to the resistance value. The acquisition module is used for acquiring the resistance value of the hot surface igniter, and the current temperature of the hot surface igniter is obtained by means of the relationship between the resistance and temperature, so that the temperature measurement function is achieved, and the measured temperature is more accurate. Further disclosed is a temperature measurement method for temperature control of the hot surface igniter.

## Description

### TECHNICAL FIELD

The present disclosure relates to a temperature measurement system, and in particular, to a temperature measurement system and method for temperature control of a hot surface igniter.

### BACKGROUND

Currently, high-frequency ignition is commonly used as the ignition method for igniters. That is, when an igniter is powered on, a high-frequency high-voltage is generated and applied to a discharge electrode, causing spark discharge to produce electric sparks, thus igniting a combustible gas. However, such igniters employing high-frequency ignition generate electric sparks during operation, and thus have disadvantages such as noise pollution and easy formation of unsafe combustion and explosion. To this end, safer hot surface igniters are gradually replacing the high-frequency igniters. As an automatic ignition device, the hot surface igniter utilizes a hot surface ignition technology, which can allow combustible gas/fuel to enter a combustion area after the hot surface igniter has reached a high temperature in advance, thereby completely avoiding potential problems caused by the electric sparks.

Since the temperature that the hot surface igniter can eventually reach is related to the magnitude of a voltage supplied to the hot surface igniter, the temperature of the hot surface igniter can be adjusted by adjusting a supply voltage of the hot surface igniter. However, in practice, on the one hand, in order to bring the hot surface igniter to the required temperature quickly, the supply voltage of the hot surface igniter is usually increased; whereas in order to minimize damage to the hot surface igniter, it is necessary to timely reduce and adjust the supply voltage once the required temperature is reached. On the other hand, since the hot surface igniter needs to reach different temperatures under different application operating conditions, it is necessary to adjust the supply voltage according to the temperature.

Chinese patent document no. CN 1640195 B discloses a voltage adjustment system and method for a resistance igniter. In said system and method, a line voltage of the system is determined and a voltage applied to the resistance igniter is controlled, such that a first voltage initially applied is maintained for a period of time, after which a second voltage is applied, the second voltage being a rated voltage of the igniter. In said system and method, a line voltage of the system is determined and a voltage applied to the resistance igniter is controlled, such that a first voltage initially applied is maintained for a period of time, after which a second voltage is applied, the second voltage being a rated voltage of the igniter. Said system and method reduce the time required for heating the resistance igniter to a temperature sufficient to ignite a gas while adjusting an output voltage supplied to the igniter to prevent damage to the igniter caused by overvoltage. Said system and method reduce the time required for heating the resistance igniter to a temperature sufficient to ignite a gas while adjusting an output voltage supplied to the igniter to prevent damage to the igniter caused by overvoltage.

The drawbacks are: in this invention, the output voltage is measured, but an actual voltage supplied to the hot surface igniter in the entire circuit is not exactly equal to the output voltage, it is inaccurate to use the output voltage to characterize the voltage of the hot surface igniter, causing an incorrect voltage to be supplied to the hot surface igniter, which in turn leads to an inaccurate heating temperature of the hot surface igniter.

### SUMMARY

In order to solve the problem of inaccurate temperature control of a hot surface igniter in the prior art, the present disclosure provides a temperature measurement system for temperature control of a hot surface igniter, the temperature measurement system comprising: a power supply module, configured to supply power to the hot surface igniter; and
wherein the temperature measurement system further comprises: an acquisition module, configured to acquire a resistance value of the hot surface igniter; and
a processing module in which a resistance-temperature table is preset and which is configured to acquire a temperature value corresponding to a present resistance value from the preset resistance-temperature table according to the resistance value.

Taking into account that the heat generated by the hot surface igniter comes from the heat generated by a thermal resistor of the hot surface igniter itself, and also a thermal resistor has a positive temperature coefficient that changes with the temperature of the hot surface igniter, which means that the resistance value of the thermal resistor also changes during the heating process, and thus this solution chooses to use the resistance value to characterize the temperature of the hot surface igniter. The resistance value is first acquired, and then the temperature value is looked up from the preset resistance-temperature table. Compared with the prior art, the resistance value obtained in this solution is closer to the resistance value of the hot surface igniter itself, so the obtained temperature value is more accurate, and the subsequent temperature control of the hot surface igniter is also more accurate.

Preferably, the acquisition module comprises a current measurement circuit for acquiring a current value of the hot surface igniter, a terminal voltage measurement circuit for acquiring a terminal voltage of the hot surface igniter, and a processing unit for calculating the resistance value from the terminal voltage. In this solution, the relationship between voltage and current is used to indirectly characterize the resistance value. With the current measurement circuit and the terminal voltage measurement circuit, the resistance value of the hot surface igniter itself is calculated, and the operation is simple.

Preferably, the current measurement circuit comprises a first sampling resistor connected to a positive voltage terminal of supplied power of the power supply module and to one electrode of the hot surface igniter, and a first amplifier circuit for amplifying a voltage of the first sampling resistor, the other electrode of the hot surface igniter being electrically connected to a negative voltage terminal of the power supply module. In this solution, when power is supplied to the hot surface igniter, the current flowing through the hot surface igniter will flow in a direction of flowing through the positive voltage terminal of supplied power, the first sampling resistor, the one electrode of the hot surface igniter, the hot surface igniter, and the other electrode of the hot surface igniter, and finally returning to the negative voltage terminal of the supplied power. The current flowing through the hot surface igniter may be converted into a small voltage by the first sampling resistor. After amplification by the first amplifier circuit, a voltage Vrt linearly related to the current flowing through the hot surface igniter is outputted. Finally, the processing module calculates the present current value of the hot surface igniter according to the proportional relationship between the voltage Vrt and the current of the hot surface igniter. The structure is simple.

Preferably, the terminal voltage measurement circuit comprises a positive voltage terminal of supplied power, a second sampling resistor, a third sampling resistor, and a negative voltage terminal of the supplied power that are sequentially connected in series, as well as a second amplifier circuit for amplifying a terminal voltage of the third sampling resistor, the second sampling resistor and the third sampling resistor being connected in series with each other and then being connected in parallel with the hot surface igniter. In this solution, the second sampling resistor and the third sampling resistor are connected in series, and the hot surface igniter is connected in parallel with the series-connected second sampling resistor and third sampling resistor, and thus after acquiring the terminal voltage of the third sampling resistor using the second amplifier circuit, the present voltage value of the hot surface igniter may be calculated according to the proportional relationship between the terminal voltage of the third sampling resistor and the terminal voltage of the hot surface igniter. The structure is simple.

Preferably, the power supply module adopts a wide voltage input. In this solution, the wide voltage input method can meet the requirements of the hot surface igniter with different rated operating voltages, thereby expanding the application range of the hot surface igniter.

Preferably, the power supply module further comprises an H-bridge driving circuit that makes a current direction change periodically. In this solution, the H-bridge driving circuit may, on the one hand, prolong the service life of the hot surface igniter, and on the other hand, can significantly improve the stability of the thermal resistor of the hot surface igniter, making the correlation between the thermal resistance and the temperature more stable, thereby ensuring the accuracy of the resulting temperature.

In a second aspect, the present disclosure further provides a temperature measurement method for temperature control of a hot surface igniter, the temperature measurement method comprising: a power supply step: supplying power to the hot surface igniter;
an acquisition step: acquiring a resistance value of the hot surface igniter; and
a processing step: acquiring a temperature value corresponding to a present resistance value from a preset resistance-temperature table according to the resistance value.

The present disclosure has the following advantageous effects:
1. In the present disclosure, the current measurement circuit and the terminal voltage measurement circuit are used to measure the current value and voltage value of the hot surface igniter, respectively, and then the present resistance value of the hot surface igniter itself is calculated, and the present temperature of the hot surface igniter is obtained through the relationship between the resistance and the temperature, to achieve the temperature measurement function. Compared with the prior art, the temperature measured in the present disclosure is more accurate;
2. Considering that the rated voltage required by the hot surface igniter in practical applications may vary according to the actual operating conditions, the present disclosure adopts a wide voltage input to meet the voltage requirements of the hot surface igniter under more operating conditions.
3. Furthermore, to improve the accuracy of the temperature measurement structure, the present disclosure is further provided with an H-bridge driving circuit to improve the stability of the thermal resistor of the hot surface igniter, such that the relationship between the thermal resistance and the temperature tends to be stable.

### BRIEF DESCRIPTION OF THE DRAWINGS

FIG. 1 is a block diagram of modules of an embodiment of a temperature measurement system and method for temperature control of a hot surface igniter according to the present disclosure;
FIG. 2 is a circuit diagram of an H-bridge driving circuit;
FIG. 3 is a diagram of a current measurement circuit; and
FIG. 4 is a diagram of a terminal voltage measurement circuit.

### DETAILED DESCRIPTION OF THE EMBODIMENTS

Further detailed description is made below in combination with specific embodiments:

### 1. Definition

Wide voltage input: in the present disclosure, the wide voltage input range is 9 V-36 V.

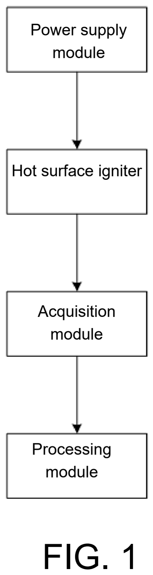

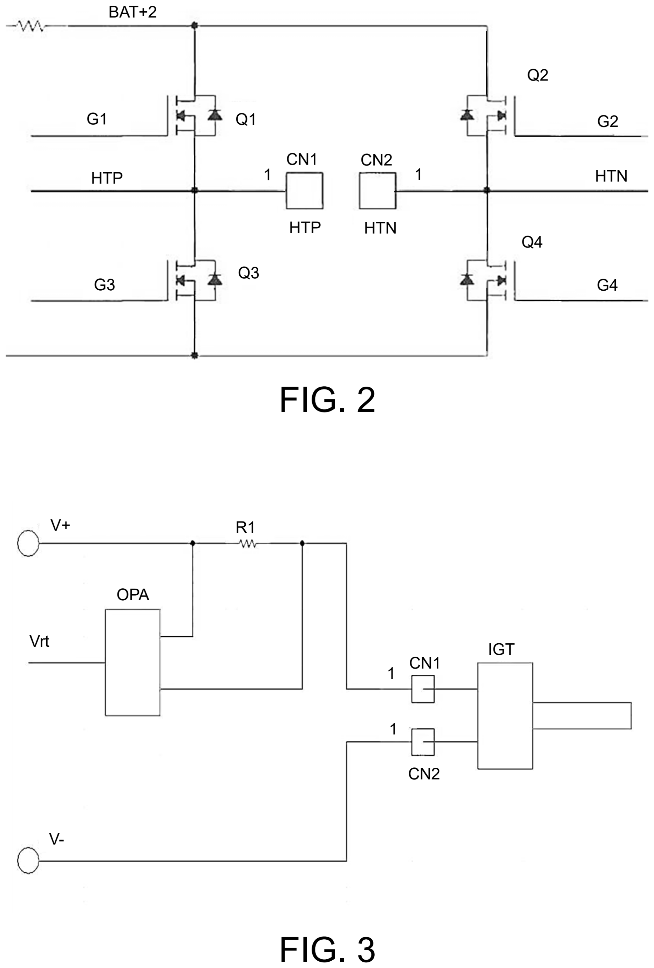

2. The embodiment is substantially as shown in FIG. 1: a temperature measurement system for temperature control of a hot surface igniter, comprises: a power supply module, which is configured to supply power to the hot surface igniter, and uses a wide voltage input. In particular, a high-efficiency and high-performance DC-DC conversion circuit is applied in the present embodiment, and the purpose thereof is to meet applications within the wide voltage input range (9 V-36 V). The power supply module further comprises an H-bridge driving circuit that makes a current direction change periodically, as shown in FIG. 2.

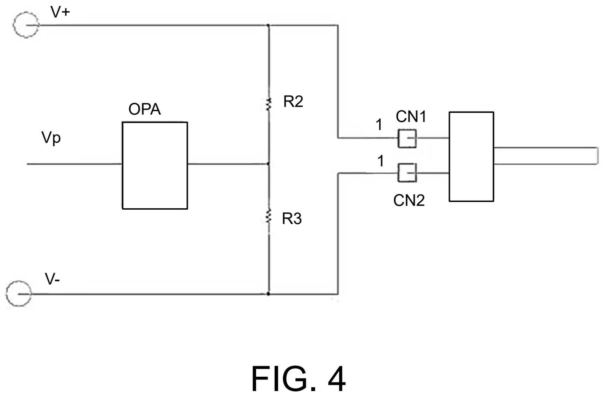

An acquisition module, configured to acquire a resistance value of the hot surface igniter; in particular, the acquisition module comprises a current measurement circuit for acquiring a current value of the hot surface igniter, a terminal voltage measurement circuit for acquiring a terminal voltage of the hot surface igniter, and a processing unit for calculating the resistance value from the current value and the terminal voltage. In particular, the current measurement circuit comprises a first sampling resistor connected to a positive voltage terminal of supplied power of the power supply module and to one electrode of the hot surface igniter, and a first amplifier circuit for amplifying a voltage of the first sampling resistor, the other electrode of the hot surface igniter being electrically connected to a negative voltage terminal of the power supply module, as shown in FIG. 3. The terminal voltage measurement circuit comprises a positive voltage terminal of supplied power, a second sampling resistor, a third sampling resistor, and a negative voltage terminal of the supplied power that are sequentially connected in series, as well as a second amplifier circuit for amplifying a terminal voltage of the third sampling resistor, the second sampling resistor and the third sampling resistor being connected in series with each other and then being connected in parallel with the hot surface igniter, as shown in FIG. 4. When the terminal voltage and current value of the hot surface igniter are acquired, the processing module calculates the resistance value of the hot surface igniter using a calculation formula: resistance = voltage/current.

A processing module, in which a resistance-temperature table is preset and which is configured to acquire a temperature value corresponding to a present resistance value from the preset resistance-temperature table according to the acquired resistance value.

The present embodiment further discloses a measurement method based on the described measurement system, the measurement method comprising: a power supply step: supplying power to a hot surface igniter;
an acquisition step: acquiring a resistance value of the hot surface igniter; and
a processing step: acquiring a temperature value corresponding to a present resistance value from a preset resistance-temperature table according to the resistance value.

The specific implementation process is as follows: when used, the temperature measurement system of the present disclosure is powered by the power supply module. When power is supplied, the H-bridge driving circuit drives to reverse the current flowing through the hot surface igniter, as shown in FIG. 2; wherein CN1 and CN2 of the H-bridge driving circuit are connection points of the two electrodes of the hot surface igniter, and the driving circuit comprises four MOSFETs Q1, Q4, Q2, and Q3, which are turned on and off in a preset sequence to achieve the reversal of the current flowing through the hot surface igniter.

When measuring the current of the hot surface igniter, as shown in FIG. 3, IGT represents the hot surface igniter, R1 represents the first sampling resistor, OPA represents the first amplifier circuit, and V+ and V- represent the positive voltage terminal and the negative voltage terminal of the supplied power of the hot surface igniter, respectively. When power is supplied to the hot surface igniter IGT, the current I flowing through the hot surface igniter IGT will flow in a direction flowing through V+, R1, CN1, the hot surface igniter IGT, and CN2, and finally returning to V-. The current flowing through the hot surface igniter IGT can be converted into a small voltage by the first sampling resistor R1. After amplifying by the first amplifier circuit OPA, a voltage Vrt linearly related to the current I flowing through the hot surface igniter is outputted, and the voltage Vrt is sent to the processing unit. The processing module calculates the present current value of the hot surface igniter IGT according to the proportional relationship between the voltage Vrt and the current of the hot surface igniter IGT.

When measuring the voltage of the hot surface igniter, the terminal voltage measurement circuit shown in FIG. 4 may acquire a voltage value Vp representing the magnitude of the terminal voltage, and send the voltage value Vp to the processing unit. The processing unit calculates the present terminal voltage of the hot surface igniter according to the proportional relationship between the voltage value Vp and the terminal voltage of the hot surface igniter IGT. Finally, the processing unit may calculate the present resistance value (i.e. thermal resistance) Rt of the hot surface igniter according to the measured voltage and current of the hot surface igniter. Then, the processing module may look up the temperature value corresponding to the resistance value from the preset resistance-temperature table according to the obtained resistance value.

The content as described above merely relates to embodiments of the present disclosure, and common general knowledge such as well-known specific structures and characteristics in the solution is not redundantly described herein. A person of ordinary skill in the art would have been aware of all common technical knowledge in the technical field to which the present disclosure belongs before the filing date or the priority date, and would have access to all the prior art in the field, and have the capacity to apply routine experimental means before the date. Under the motivation provided in the present application, a person of ordinary skill in the art would have been able to improve and implement the present solution in combination with the capability thereof. Some typical well-known structures or well-known methods should not be obstacles for a person of ordinary skill in the art to implement the present application. It should be noted that, for a person skilled in the art, various modifications and improvements can also be made without departing from the structure of the present disclosure, and these modifications and improvements shall also be considered as belonging to the scope of protection of the present disclosure; and these modifications and improvements all do not affect the effect of implementation of the present disclosure and the applicability of the patent. The scope of protection of the present application shall be subject to the content of the claims, and the disclosure of specific embodiments and the like in the description can be used to interpret the content of the claims.

## Claims

1. A temperature measurement system for temperature control of a hot surface igniter, the temperature measurement system comprising: a power supply module, configured to supply power to the hot surface igniter;
wherein the temperature measurement system further comprises: an acquisition module, configured to acquire a resistance value of the hot surface igniter; and
a processing module in which a resistance-temperature table is preset and which is configured to acquire a temperature value corresponding to a present resistance value from the preset resistance-temperature table according to the resistance value.

2. The temperature measurement system for temperature control of a hot surface igniter according to claim 1, wherein the acquisition module comprises a current measurement circuit for acquiring a current value of the hot surface igniter, a terminal voltage measurement circuit for acquiring a terminal voltage of the hot surface igniter, and a processing unit for calculating the resistance value from the current value and the terminal voltage.

3. The temperature measurement system for temperature control of a hot surface igniter according to claim 2, wherein the current measurement circuit comprises a first sampling resistor connected to a positive voltage terminal of supplied power of the power supply module and to one electrode of the hot surface igniter, and a first amplifier circuit for amplifying a voltage of the first sampling resistor, the other electrode of the hot surface igniter being electrically connected to a negative voltage terminal of the power supply module.

4. The temperature measurement system for temperature control of a hot surface igniter according to claim 3, wherein the terminal voltage measurement circuit comprises a positive voltage terminal of supplied power, a second sampling resistor, a third sampling resistor, and a negative voltage terminal of the supplied power that are sequentially connected in series, as well as a second amplifier circuit for amplifying a terminal voltage of the third sampling resistor, the second sampling resistor and the third sampling resistor being connected in series with each other and then being connected in parallel with the hot surface igniter.

5. The temperature measurement system for temperature control of a hot surface igniter according to any one of claims 1-4, wherein the power supply module adopts a wide voltage input.

6. The temperature measurement system for temperature control of a hot surface igniter according to claim 5, wherein the power supply module further comprises an H-bridge driving circuit that makes a current direction change periodically.

7. A temperature measurement method for temperature control of a hot surface igniter, the temperature measurement method comprising: a power supply step: supplying power to the hot surface igniter; and
wherein the temperature measurement method further comprises: an acquisition step: acquiring a resistance value of the hot surface igniter; and
a processing step: acquiring a temperature value corresponding to a present resistance value from a preset resistance-temperature table according to the resistance value.
